# EUROPÄISCHE PATENTSCHRIFT

(11) **EP 1 983 593 B1**
(45) Veröffentlichungstag und Bekanntmachung des Hinweises auf die Patenterteilung: **04.04.2018**
(21) Anmeldenummer: 08154719.2
(22) Anmeldetag: 17.04.2008
(51) Int. Cl.: H01L 51/52

(54) **Organisches optoelektronisches Bauelement**
Organic optoelectronic component
Composant organique optoélectronique

(30) Priorität: 18.04.2007 DE 102007018301; 24.05.2007 DE 102007024152
(43) Veröffentlichungstag der Anmeldung: 22.10.2008
(73) Patentinhaber: OSRAM OLED GmbH, 93049 Regensburg (DE)
(72) Erfinder: Dobbertin, Thomas, 93051, Regensburg (DE); Klein, Markus, 93105, Tegernheim (DE)
(74) Vertreter: Epping - Hermann - Fischer

(56) Entgegenhaltungen:
- WO-A1-2006/134093
- US-A1- 2002 036 297
- US-A1- 2006 214 565
- US-A1- 2006 220 534
- US-A1- 2006 228 543
- US-A1- 2006 261 333
- US-A1- 2006 273 714
- US-A1- 2007 077 349

## Beschreibung

Es werden ein organisches optoelektronische Bauelement und ein Verfahren zur Herstellung eines organischen optoelektronischen Bauelements gemäß der unabhängigen Patentansprüche angegeben.

Aus der Druckschrift US 2002/036297 A1 ist eine organische Licht emittierende Diode (OLED) bekannt, die auf einem Substrat eine untere Elektrode, darüber organische Schichten und darüber eine Elektrodeninjektionsschicht (EIL), eine erste Kathodenschicht sowie eine zweite Kathodenschicht aufweist. Die EIL ist aus MgAg oder CuPc. Die erste Kathodenschicht ist aus einem Metall, einer Legierung oder einer intermetallischen Verbindung, während die zweite Kathodenschicht aus einem leitfähigen Oxid ist.

Die Druckschrift US 2007/0077349 A1 beschreibt ein OLED-Display, das auf einem Substrat eine Mehrzahl von Bottom-Elektroden, organische Schichten und eine gemeinsame lichtdurchlässige Elektrode aufweist. Auf der Elektrode ist eine strukturierte leitfähige Schicht in Kontakt mit der Elektrode aufgebracht, die beispielsweise aus metallischen Nanopartikeln gebildet ist.

Die Druckschrift US 2006/0261333 A1 beschreibt eine OLED, bei der die organischen Schichten vor dem Aufbringverfahren der Top-Elektrode geschützt werden sollen. Hierzu wird auf den organischen Schichten vor der Top-Elektrode eine Pufferschicht aufgebracht, die beispielsweise aus Wolframoxid, Molybdänoxid oder Vanadiumoxid sein kann.

Zumindest eine Aufgabe von bestimmten Ausführungsformen ist es, ein organisches optoelektronisches Bauelement anzugeben, das geeignet ist, elektromagnetische Strahlung zu emittieren. Dadurch können beispielsweise eine Beleuchtung oder eine Informationsanzeige ermöglicht werden. Weiterhin ist es eine Aufgabe von bestimmten Ausführungsformen, ein Verfahren zur Herstellung eines organischen optoelektronischen Bauelements anzugeben.

Diese Aufgaben werden durch einen Gegenstand und ein Verfahren mit den Merkmalen der unabhängigen Patentansprüche gelöst. Vorteilhafte Ausführungsformen und Weiterbildungen des Gegenstands und des Verfahrens sind in den abhängigen Ansprüchen gekennzeichnet und gehen weiterhin aus der nachfolgenden Beschreibung und den Zeichnungen hervor.

Ein organisches optoelektronische Bauelement gemäß einer Ausführungsform der Erfindung umfasst insbesondere
- ein Substrat,
- eine erste Elektrode auf dem Substrat,
- zumindest eine erste organische Schichtenfolge auf der ersten Elektrode, die geeignet ist, im Betrieb elektromagnetische Strahlung abzustrahlen,
- eine elektrisch leitende anorganische Schutzschicht auf der zumindest einen organischen Schichtenfolge und
- eine zweite Elektrode auf der anorganischen Schutzschicht, wobei
- zumindest eine der ersten und zweiten Elektrode (2, 5) eine Schichtenfolge (21, 22, 23) aufweist, die eine transparente Oxidschicht (21) und eine transparente Metallschicht (22) umfasst,
- auf der zweiten Elektrode (5) ein Material (7) aufgebracht ist, das Kohlenstoffnanoröhrchen oder metallische Nanopartikel aufweist,
- die anorganische Schutzschicht (4) ein Übergangsmetalloxid aus der Gruppe Rheniumoxid und Nickeloxid umfasst.

Dabei kann hier und im Folgenden eine Schicht oder ein Element "auf" oder "über" einer anderen Schicht oder einem anderen Element bedeuten, dass die eine Schicht oder das eine Element unmittelbar im direkten mechanischen und/oder elektrischen Kontakt auf der anderen Schicht oder dem anderen Element angeordnet ist. Weiterhin kann es auch bedeuten, dass die eine Schicht oder das eine Element mittelbar auf beziehungsweise über der anderen Schicht oder dem anderen Element angeordnet ist. Dabei sind dann weitere Schichten und/oder Element zwischen der einen und der anderen Schicht angeordnet.

Die erste organische Schichtenfolge kann durch die elektrisch leitende anorganische Schutzschicht sowohl im Betrieb als auch insbesondere bei der Herstellung des Bauelements vor Beeinträchtigungen und/oder Schädigungen geschützt werden. Solche Beeinträchtigungen oder Schädigungen können etwa bei der Herstellung des organischen optoelektronischen Bauelements auftreten. Eine Beeinträchtigung oder Schädigung der ersten organischen Schichtenfolge kann sich beispielsweise in einer geringeren Lebensdauer des organischen optoelektronischen Bauelements und/oder in einer geringeren Abstrahlintensität der im Betrieb erzeugten elektromagnetischen Strahlung auswirken. Insbesondere kann es durch die Schutzschicht etwa ermöglicht werden, dass die zweite Elektrode mittels eines Verfahrens aufgebracht werden kann, das die erste organische Schichtenfolge ohne das Vorhandensein der anorganischen Schutzschicht beeinträchtigen oder sogar schädigen würde. Beispielsweise kann es wünschenswert oder erforderlich sein, dass die zweite Elektrode oder zumindest ein Teil der zweiten Elektrode mittels eines Verfahrens zur Kathodenzerstäubung ("sputtering") über der ersten organischen Schichtenfolge aufgebracht wird. Ein derartiger hochenergetischer Prozess könnte bei Abwesenheit der Schutzschicht durch den möglichen Beschuss der organischen Schichtenfolge mit Gasionen und/oder dem aufzusputternden Material beziehungsweise den Materialpartikeln zu einer Degradation der organischen Schichtenfolge und damit zu einer reduzierten Leistungsfähigkeit und Zuverlässigkeit des organischen optoelektronischen Bauelements führen. Ein Verfahren zur Kathodenzerstäubung kann etwa geeignet sein, ein transparentes Oxid über der organischen Schichtenfolge aufzubringen und abzuscheiden. Weiterhin können auch Metalle oder Metallverbindungen mittels Sputtern aufgebracht werden.

Beispielsweise kann die zweite Elektrode eine Schichtenfolge umfassen, die als transparente Oxidschicht eine Schicht mit einem transparenten Oxid und als transparente Metallschicht eine Schicht mit einem Metall aufweist, das derart ausgeführt ist, dass es transparent ist. Beispielsweise kann die Metallschicht eine derart geringe Dicke aufweisen, dass das Metall transparent ist. Dadurch kann die zweite Elektrode transparent sein. Insbesondere kann eine "transparente" Elektrode hier und im Folgenden bedeuten, dass zumindest ein Teil der von der organischen Schichtenfolge im Betrieb erzeugten elektromagnetischen Strahlung durch die Elektrode aus der organischen Schichtenfolge und damit vom organischen optoelektronischen Bauelement abgestrahlt werden kann. Das organische optoelektronische Bauelement kann damit also geeignet sein, elektromagnetische Strahlung durch die zweite Elektrode abzustrahlen ("top emitter").

Alternativ oder zusätzlich kann auch die erste Elektrode transparent sein, wobei alternativ oder zusätzlich die erste Elektrode eine transparente Schichtenfolge umfassend eine transparente Oxidschicht und eine transparente Metallschicht aufweisen kann. Weiterhin kann auch das Substrat transparent sein. Das organische optoelektronische Bauelement kann damit geeignet sein, durch die erste Elektrode und das Substrat elektromagnetische Strahlung abzustrahlen ("bottom emitter"). Das Substrat kann insbesondere ein transparentes Material aufweisen. Dabei kann das Substrat Glas, Quarz, Kunststoff, Kunststofffolien, Metall, Metallfolien, Siliziumwafer oder ein beliebiges anderes geeignetes Substratmaterial umfassen. Insbesondere kann das Substrat auch ein Laminat oder eine Mischung der vorher genannten Materialien aufweisen.

Weiterhin kann "transparent" auch bedeuten, dass die erste und/oder die zweite Elektrode und/oder das Substrat für von der Umgebung auf das organische optoelektronische Bauelement eingestrahlte elektromagnetische Strahlung zumindest teilweise durchlässig sind. Sind etwa die erste und die zweite Elektrode sowie das Substrat transparent, ist also das organische optoelektronische Bauelement sowohl als "top emitter" als auch als "bottom emitter" ausgeführt, kann das optoelektronische Bauelement transparent und damit zumindest teilweise durchsichtig sein sowie geeignet sein, elektromagnetische Strahlung aus der ersten organischen Schichtenfolge beidseitig durch die erste und die zweite Elektrode abzustrahlen.

Darüber hinaus kann das optoelektronische Bauelement eine Verkapselung über der zweiten Elektrode aufweisen, um beispielsweise für die Elektroden und die erste organische Schichtenfolge einen Schutz vor Feuchtigkeit und/oder oxidierenden Substanzen wie etwa Sauerstoff zu erreichen. Die Verkapselung kann dabei eine oder mehrere Schichten umfassen, wobei die Schichten der Verkapselung beispielsweise Planarisierungsschichten, Barriereschichten, Wasser und/oder Sauerstoff absorbierende Schichten, Verbindungsschichten oder Kombinationen daraus sein können. Die Verkapselung kann beispielsweise eine Abdeckung in Form einer Kappe, insbesondere einer freitragenden Kappe, und/oder eine Schicht oder Schichtenfolge auf beziehungsweise über der zweiten Elektrode aufweisen. Geeignete Materialien können beispielsweise Glas, Kunststoffe, Metalle, Metalloxide, Nicht-Metall-Oxide oder Nicht-Metall-Nitride wie etwa SiOₓ oder SiNₓ, Keramiken oder Kombinationen daraus aufweisen oder sein. Weiterhin kann die Abdeckung auch als Laminat ausgeführt sein. Insbesondere kann die Verkapselung transparent sein, so dass das organische optoelektronische Bauelement auch mit der Verkapselung transparent ausgeführt sein kann. Zusätzlich kann über der zweiten Elektrode, etwa auf einer den Elektroden und der organischen Schichtenfolge zugewandten Seite der Verkapselung, ein Gettermaterial aufgebracht sein. Als Gettermaterial kann vorzugsweise ein oxidierbares Material eingesetzt werden, welches mit Sauerstoff und Feuchtigkeit reagieren und diese Schadstoffe dabei binden kann. Als leicht oxidierende Materialien werden insbesondere Metalle aus der Gruppe der Alkali- und Erdalkali-Metalle eingesetzt. Beispielsweise kann das Gettermaterial Magnesium, Calcium, Barium und/oder Cäsium aufweisen. Weiterhin können auch andere Metalle, wie beispielsweise Aluminium, Zirkonium, Tantal, und/oder Titan oder oxidierbare nichtmetallische Materialien geeignet sein. Darüber hinaus kann das Gettermaterial Materialien aus der Zeolithgruppe und/oder Silikagel aufweisen.

Insbesondere kann das organische optoelektronische Bauelement über der zweiten Elektrode eine Verkapselung aufweisen und das Substrat und die Verkapselung können transparent sein.

Durch die Kombination einer transparenten Metallschicht und einer transparenten Oxidschicht kann eine erste und/oder eine zweite Elektrode realisiert werden, die sowohl gute elektrische als auch gute optische Eigenschaften aufweist. "Gute elektrische Eigenschaften" kann dabei bedeuten, dass die Elektrode einen für Metalle typischen geringen elektrischen Widerstand aufweist und damit auch eine gute Querleitfähigkeit, also eine hohe, für ein Metall typische elektrische Leitfähigkeit entlang der Erstreckungsrichtung der Elektrode aufweist. Insbesondere kann durch die Kombination einer transparenten Metallschicht und einer transparenten Oxidschicht ein geringerer elektrischer Widerstand und damit eine höhere Querleitfähigkeit erreicht werden als beispielsweise mit einer Schicht aus einem transparenten elektrisch leitenden Oxid alleine. "Gute optische Eigenschaften" kann insbesondere bedeuten, dass die Elektrode eine hohe Transparenz und weiterhin eine geringe Reflektivität, insbesondere eine geringere Reflektivität als eine Schicht mit einem transparenten Metall alleine, aufweist. Das kann dadurch erreicht werden, dass die transparente Oxidschicht als Entspiegelung wirken kann. Hierzu können Materialien mit hohem Brechungsindex wie etwa dielektrische Oxide, etwa Siliziumoxid oder Tantaloxid, und insbesondere transparente elektrisch leitende Oxide oder Mischungen daraus geeignet sein. Ein hoher Brechungsindex kann dabei beispielsweise ein Brechungsindex von größer oder gleich 1,9 sein. Beispielsweise können TCOs Brechungsindizes im Bereich von etwa 1,9 bis etwa 2,1 aufweisen. Alternativ oder zusätzlich kann die erste und/oder zweite Elektrode auch eine oder mehrere zur Entspiegelung geeignete Schichten aus einem weiteren Material mit hohem Brechungsindex aufweisen, etwa aus dem Bereich der Telluride oder Sulfide, etwa ZnSe mit einem Brechungsindex von etwa 2,5. Darüber hinaus können die genannten Materialien auch in Kombinationen oder Mischungen in der ersten und/oder zweiten Elektrode vorliegen.

Transparente elektrisch leitende Oxide (transparent conductive oxides, kurz "TCO") können transparente, leitende Materialien, in der Regel Metalloxide, wie beispielsweise Zinkoxid, Zinnoxid, Cadmiumoxid, Titanoxid, Indiumoxid, Aluminiumzinkoxid, Indiumzinnoxid (ITO) und Indiumzinkoxid sein. Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter elektrisch leitender Oxide zu der Gruppe der TCOs. Weiterhin müssen die TCOs nicht zwingend einer stöchiometrischen Zusammensetzung entsprechen und können auch p- oder n-dotiert sein.

Zumindest eine der ersten und zweiten Elektrode kann weiterhin eine Schichtenfolge umfassen, die eine erste Schicht mit einem ersten transparenten elektrisch leitenden Oxid (TCO), eine zweite Schicht mit einem transparenten Metall und eine dritte Schicht mit einem zweiten TCO aufweist. Durch die Schichtenfolge mit zwei Schichten, die jeweils ein TCO aufweisen und einer Schicht dazwischen, die als transparente Metallschicht ausgeführt ist, kann eine Elektrode ermöglicht werden, die dank der transparenten Metallschicht eine hohe Querleitfähigkeit und dank der hochbrechenden TCO-aufweisenden Schichten ein reduziertes Reflexionsvermögen aufweist. Für ein beidseitig transparentes, also volldurchsichtiges, organisches optoelektronisches Bauelement können auch beide Elektroden jeweils eine solche Schichtenfolge umfassen. Insbesondere kann dadurch erreicht werden, dass durch die zwei transparenten Elektroden gerade kein optischer Mikroresonator ausgebildet wird oder zumindest ein Mikroresonator mit geringer Güte.

Das erste TCO und/oder das zweite TCO kann dabei eines oder mehrere der oben genannten Materialien für TCOs aufweisen. Insbesondere kann das erste TCO und/oder das zweite TCO ITO, Indiumzinkoxid, Aluminiumzinkoxid und/oder Zinkoxid aufweisen oder aus einem solchen sein. Weiterhin können das erste und/oder das zweite TCO mit Aluminium, Vanadium und/oder Gallium oder einer Kombination oder Mischung daraus dotiert sein. Eine Schicht mit einem TCO kann insbesondere größer oder gleich 5 nm und kleiner oder gleich 150 nm sein.

Das transparente Metall kann Aluminium, Chrom, Molybdän, Nickel, Silber, Platin, Barium, Indium, Gold, Magnesium, Calcium oder Lithium sowie Verbindungen, Kombinationen und Legierungen aufweisen oder aus einem der genannten Materialien oder Kombinationen oder Legierungen daraus bestehen. Dabei kann eine Schicht mit einem transparenten Metall eine Dicke von größer oder gleich 1 nm und kleiner oder gleich 50 nm, insbesondere größer oder gleich 20 nm und kleiner oder gleich 40 nm, aufweisen.

Insbesondere können die erste Elektrode und/oder die zweite Elektrode flächig oder alternativ in erste beziehungsweise zweite Elektrodenteilbereiche strukturiert ausgeführt sein. Beispielsweise kann die erste Elektrode in Form parallel nebeneinander angeordneter erster Elektrodenstreifen ausgeführt sein und die zweite Elektrode als senkrecht dazu verlaufende parallel nebeneinander angeordnete zweite Elektrodenstreifen. Überlappungen der ersten und zweiten Elektrodenstreifen können damit als separat ansteuerbare Leuchtbereiche ausgeführt sein. Weiterhin kann auch nur die erste oder die zweite Elektrode strukturiert sein. Beispielsweise kann die elektronische Vorrichtung etwa als eine strukturierte Beleuchtungseinrichtung oder auch als ein Display in einer Aktiv-Matrix- oder einer Passiv-Matrix-Ausführung zur Anzeige alphanumerischer und/oder graphischer Informationen ausgeführt sein.

Die anorganische elektrisch leitende Schutzschicht umfasst ein Übergangsmetalloxid ausgewählt aus Rheniumoxid und Nickeloxid, wobei die anorganische elektrisch leitende Schutzschicht Kombinationen oder Mischungen daraus aufweisen kann oder daraus bestehen kann. Weiter kann die anorganische Schutzschicht auch Metalle wie etwa Magnesium oder Silber aufweisen. Zusätzlich zur anorganischen Schutzschicht können auch noch organische Materialien wie etwa Metallophtallocyanine aufgebracht werden. Die anorganische Schutzschicht kann weiterhin eine einzelne Schicht oder eine Schichtenfolge aus mehreren Schichten mit einem oder mehreren der genannten Materialien aufweisen und kann alternativ oder zusätzlich homogen ausgeführt sein oder mehrere Bereiche mit verschiedenen Mischungen und/oder Zusammensetzungen der vorher genannten Materialien aufweisen. Darüber hinaus kann die Schutzschicht auch gänzlich oder teilweise mit einer benachbarten organischen Schicht der ersten organischen Schichtenfolge durchmischt und/oder kombiniert sein.

Über oder auf der Schutzschicht und/oder über oder auf der ersten oder zweiten Elektrode kann weiterhin ein Metall aufgebracht sein, das geeignet sein kann, eine gleichmäßige Bestromung der ersten organischen Schichtenfolge zu unterstützen. Beispielsweise kann das Metall in einer unstrukturierten gleichmäßigen Schicht oder einer strukturierten Schicht beispielsweise durch Sputtern aufgebracht sein. Beispielsweise kann das Metall netzartig strukturiert sein. Erfindungsgemäß ist auf der zweiten Elektrode ein Material aufgebracht, das Kohlenstoffnanoröhrchen ("carbon nanotubes", CNT) oder metallische Nanopartikel aufweist. "Nanopartikel" kann dabei insbesondere bedeuten, dass das Material Partikel umfasst, die Größen, also etwa mittlere Korngrößen und/oder Durchmesser, von größer oder gleich 1 nm und kleiner oder gleich mehreren hundert Nanometer, insbesondere größer oder gleich 10 nm und kleiner oder gleich 100 nm, aufweisen. Die CNT und/oder die metallischen Nanopartikel können dabei elektrisch hoch leitfähige Netzwerke ausbilden und beispielsweise in Form von CNT-basierten oder selbstorganisierenden metallischen Nanokompositen oder Emulsionen daraus vorliegen und einen spezifischen elektrischen Widerstand von kleiner oder gleich 1 bis 10 Ohm/sq und mehr als 70% Transparenz aufweisen. Schichten aus solchen Materialien können beispielsweise mittels Druck- oder Sprühverfahren aufgebracht werden.

Weiterhin weist das organische optoelektronische Bauelement eine als organische Halbleiterschichtenfolge ausgebildete erste organische Schichtenfolge auf. Die organische Halbleiterschichtenfolge enthält einen aktiven Bereich, welcher geeignet ist, im Betrieb elektromagnetische Strahlung abzustrahlen. Dabei kann das organische optoelektronische Bauelement insbesondere als organische lichtemittierende Diode (OLED) ausgeführt sein. Die erste organische Schichtenfolge kann dabei einen funktionalen Bereich mit einer oder mehreren funktionalen Schichten aus organischen Materialien aufweisen. Die funktionalen Schichten können dabei beispielsweise Ladungsträgertransportschichten und/oder Licht emittierende Schichten aufweisen, also etwa Elektronentransportschichten, elektrolumineszierende Schichten, Lochinjektionsschicht und/oder Lochtransportschichten. In den funktionellen Schichten kann beim Anlegen einer Spannung beziehungsweise eines Stromes an die erste und zweite Elektrode durch Elektronen- und Löcherinjektion und -rekombination elektromagnetische Strahlung mit einer einzelnen Wellenlänge oder einem Bereich von Wellenlängen erzeugt werden. Dabei kann bei einem Betrachter ein einfarbiger, ein mehrfarbiger und/oder ein mischfarbiger Leuchteindruck erweckt werden.

Die Elektronentransportschichten, Lochinjektions- und/oder Lochtransportschichten können weiterhin zur Erhöhung der Leitfähigkeit p- und/oder n-dotiert sein. Beispielsweise kann eine Elektronentransportschicht durch Zusatz von Alkaliatomen, etwa Lithium und/oder Cäsium, dotiert sein.

Die erste organische Schichtenfolge kann insbesondere zumindest eine p-dotierte und eine n-dotierte organische Schicht aufweisen, zwischen denen zumindest eine elektrolumineszierende Schicht angeordnet ist. Die erste Elektrode kann dabei als Anode ausgebildet sein, während die zweite Elektrode als Kathode ausgebildet sein kann. Alternativ kann auch die Polarität der Elektroden vertauscht sein.

Die erste organische Schichtenfolge kann als elektrolumineszierende Schichten beispielsweise eine weißemittierende Schichtenfolge umfassen. Diese kann etwa gelb bis orange und blau bis hellblau emittierende Schichten aufweisen. Alternativ oder zusätzlich kann eine weißemittierende Schichtenfolge auch grün, blau und rot emittierende gesättigte und/oder ungesättigte Schichten aufweisen. Alternativ oder zusätzlich kann eine als elektrolumineszierende Schicht ausgeführte Schicht ein oder mehrere Emittermaterialien zur Emission elektromagnetischer Strahlung mit einer oder mehreren unterschiedlichen Wellenlängen, etwa im gelben und blauen oder im grünen, blauen und roten Spektralbereich, aufweisen.

Die funktionalen Schichten können organische Polymere, organische Oligomere, organische Monomere, organische kleine, nicht-polymere Moleküle ("small molecules") oder Kombinationen daraus aufweisen. Weiterhin können die funktionalen Schichten organische und/oder anorganische Leuchtstoffe und/oder Wellenlängenkonversionsstoffe aufweisen.

Das organische optoelektronische Bauelement kann weiterhin eine zweite organische Schichtenfolge aufweisen, die geeignet ist, im Betrieb elektromagnetische Strahlung abzustrahlen. Die zweite organische Schichtenfolge kann dabei zwischen der ersten Elektrode und der Schutzschicht angeordnet sein. Insbesondere kann die zweite organische Schichtenfolge in direktem Kontakt mit der ersten organischen Schichtenfolge angeordnet sein, so dass die erste und die zweite organische Schichtenfolge zwischen der ersten Elektrode und der Schutzschicht beziehungsweise der zweiten Elektrode in Serie geschaltet sind. Dabei kann die zweite organische Schichtenfolge eines oder mehrere der Merkmale aufweisen, die weiter oben im Zusammenhang mit der ersten organischen Schichtenfolge aufgeführt sind. Dabei kann die zweite organische Schichtenfolge wie die erste organische Schichtenfolge geeignet sein, im Betrieb einen ein-, misch- und insbesondere weiß-farbigen Leuchteindruck bei einem Betrachter zu erwecken.

Insbesondere kann das organische optoelektronische Bauelement als Beleuchtungseinrichtung ausgeführt sein, die im Betrieb einen weißfarbigen Leuchteindruck bei einem Betrachter erweckt.

Die erste und die zweite organische Schichtenfolge können derart in Serie geschaltet sein, dass eine n-dotierte organische Schicht der ersten organischen Schichtenfolge an eine p-dotierte organische Schicht der zweiten organischen Schichtenfolge angrenzt oder umgekehrt. Eine solche Kombination von benachbarten n- und p-dotierten Schichten kann auch als so genanntes "charge generation layer" (CGL) bezeichnet werden. Durch Ausbildung eines oder mehrerer "charge generation layer" direkt benachbart zu einer der beiden oder zu beiden Elektroden kann eine freie Einstellung der Polarität der Elektroden ermöglicht werden, ohne die Reihenfolge der organischen Schichten der organischen Schichtenfolgen vertauschen zu müssen.

Weiterhin kann das organische optoelektronische Bauelement weitere organische Schichtenfolgen aufweisen, für das im Zusammenhang mit der ersten und zweiten organischen Schichtenfolge Beschriebene gelten kann. Das organische optoelektronische Bauelement kann beispielsweise bis zu sechs organische Schichtenfolgen aufweisen, die in der oben beschriebenen Weise angeordnet und in Serie miteinander verschaltet sind. Eine solche Anordnung von organischen Schichtenfolgen in Form einer vertikalen Stapelung kann zu einer annähernd linearen Vergrößerung der Stromeffizienz bei der Lichterzeugung führen. Somit kann auch bei einem großflächig ausgebildeten organischen optoelektronischen Bauelement eine hohe Leuchteffizienz bei einem geringen Strombedarf ermöglicht werden. Daher kann sich ein wie oben beschriebenes organisches optoelektronisches Bauelement besonders eignen, als großflächige, weiß-farbige Beleuchtungseinrichtung mit einer Leuchtfläche von mehreren Quadratzentimetern oder mehreren Quadratdezimetern ausgebildet zu sein.

Ein Verfahren zur Herstellung eines organischen optoelektronischen Bauelements umfasst die folgenden Schritte :
A) Bereitstellen eines Substrats,
B) Aufbringen einer ersten Elektrode auf dem Substrat,
C) Aufbringen zumindest einer ersten organischen Schichtenfolge auf der ersten Elektrode,
D) Aufbringen einer elektrisch leitenden anorganischen Schutzschicht auf der organischen Schichtenfolge,
E) Aufbringen einer zweiten Elektrode auf der Schutzschicht,
wobei
Schritt B und/oder Schritt E die Teilschritte umfasst:
BE1) Aufbringen einer transparenten Metallschicht und
BE2) Aufbringen einer ersten Schicht mit einem transparenten Oxid mittels eines Kathodenzerstäubungsverfahrens,
wobei in einem weiteren Schritt F) eine Schicht (7) auf der zweiten Elektrode (5) aufgebracht wird, wobei die Schicht (7) Kohlenstoffnanoröhrchen und/oder metallische Nanopartikel umfasst,
und wobei im Verfahrensschritt D) ein Übergangsmetalloxid aus einer Gruppe aufgebracht wird und die Gruppe gebildet wird durch Rheniumoxid und Nickeloxid. Dabei können im Schritt C) die funktionalen Schichten, also die Elektronen- und/oder Lochtransportschichten und/oder elektrolumineszierende Schichten beispielsweise mittels thermischer Verdampfung, resistiver Verdampfung, Druck- oder Sprühverfahren aufgebracht werden.

Weiterhin kann Schritt B und/oder Schritt E den weiteren Teilschritt umfassen:
BE3) Aufbringen einer zweiten Schicht mit einem transparenten Oxid, wobei die Metallschicht zwischen den Schichten mit jeweils einem transparenten Oxid aufgebracht werden kann. Insbesondere können dabei in den Teilschritten BE1) und BE3) Schichten mit jeweils einem transparenten elektrisch leitenden Oxid aufgebracht werden.

Im Schritt C) können auch weiterhin in einem Teilschritt C1) die erste organische Schichtenfolge und in einem Teilschritt C2) eine zweite organische Schichtenfolge aufgebracht werden. Weiterhin kann der Schritt C) weitere Teilschritte aufweisen, in denen, wie weiter oben ausgeführt, noch weitere organische Schichtenfolgen aufgebracht werden. Insbesondere kann dabei zumindest einer Schritte C), C1 und/oder C2) folgende Teilschritte aufweisen:
Ca) Aufbringen einer ersten Ladungsträgertransportschicht,
Cb) Aufbringen einer ersten organischen elektrolumineszierenden Schicht auf die erste Ladungsträgertransportschicht,
Cc) Aufbringen einer zweiten Ladungsträgertransportschicht auf die erste organische elektrolumineszierende Schicht. Dabei kann die erste Ladungsträgertransportschicht eine Lochtransportschicht und die zweite Ladungsträgertransportschicht eine Elektronentransportschicht sein oder umgekehrt. Die Ladungsträgertransportschichten können weiterhin p- oder n-dotiert sein.

In einem weiteren Schritt F) werden, wie weiter oben ausgeführt, in einer weiteren Schicht Kohlenstoffnanoröhrchen und/oder metallische Nanopartikel auf der zweiten Elektrode aufgebracht. Beispielsweise kann dafür ein Siebdruckverfahren angewandt werden, bei dem eine Dispersion aus CNT und/oder metallischen Nanopartikeln ortselektiv in einer Schicht mit einer Dicke vom größer oder gleich 30 nm und kleiner oder gleich 200 nm aufgebracht wird, die bei etwa 50°C während einer Zeitdauer von etwa 1 Minute getrocknet wird.

Weitere Vorteile und vorteilhafte Ausführungsformen und Weiterbildungen der Erfindung ergeben sich aus den im Folgenden in Verbindung mit den Figuren 1 bis 4D beschriebenen Ausführungsformen.

Es zeigen:
Figuren 1 bis 3 schematische Darstellungen organischer optoelektronischer Bauelement im Querschnitt, und
Figuren 4A bis 4D schematische Darstellungen einer Verfahrens zur Herstellung eines organischen optoelektronischen Bauelements gemäß einem weiteren Ausführungsbeispiel.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

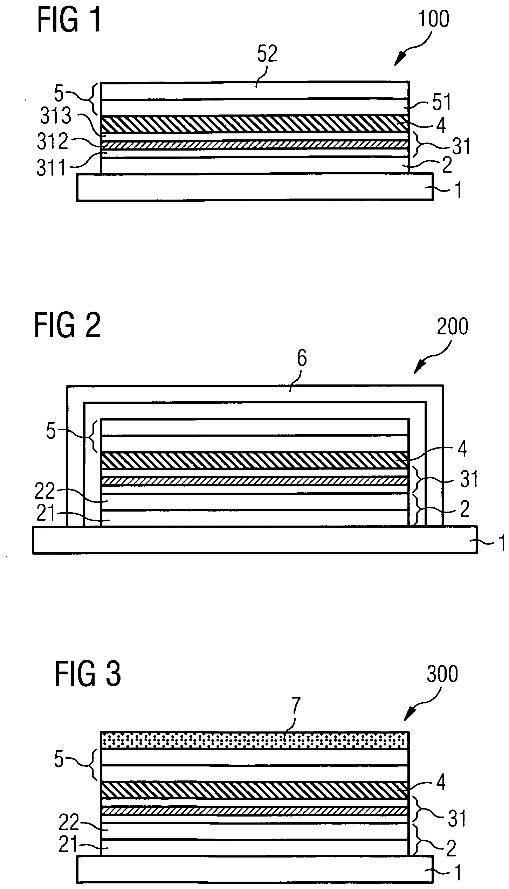

In Figur 1 ist ein Beispiel eines organischen optoelektronischen Bauelements 100 gezeigt. Dabei ist auf einem Substrat 1 eine erste Elektrode 2 aus ITO aufgebracht, die als Anode ausgeführt ist. Das Substrat 1 weist Glas auf und ist transparent. Auf der ersten Elektrode 2 ist eine erste organische Schichtenfolge 31 aufgebracht, die funktionelle Schichten 311, 312, 313 aufweist. Die Schicht 311 ist dabei als Lochtransportschicht ausgeführt, während die Schicht 313 als Elektronentransportschicht ausgeführt ist. Die Schicht 312 ist als elektrolumineszierende Schicht ausgeführt, die im Betrieb weiß-farbige elektromagnetische Strahlung abstrahlen kann. Während im gezeigten Ausführungsbeispiel lediglich eine Schicht 312 gezeigt ist, kann die elektrolumineszierende Schicht alternativ auch als Schichtenfolge mit mehreren elektrolumineszierenden Schichten ausgeführt sein wie im allgemeinen Teil beschrieben.

Über der organischen Schichtenfolge 31 ist eine anorganische elektrisch leitende Schutzschicht 4 aufgebracht, die ein Übergangsmetalloxid Re₂O₇ oder NiO umfasst. Über der Schutzschicht 4 ist eine zweite Elektrode 5 aufgebracht, die eine erste Schicht 51 und eine zweite Schicht 52 aufweist. Die erste Schicht 51 ist aus einem transparenten Metall mit einer Schichtdicke zwischen etwa 20 und etwa 40 nm, die auf die Schutzschicht 4 aufgesputtert ist. Über der Schicht 51 ist die Schicht 52 aus einem transparenten Oxid mit einer Schichtdicke zwischen etwa 5 nm und etwa 150 nm aufgebracht. Das transparente Oxid ist dabei im gezeigten Ausführungsbeispiel ein TCO, beispielsweise ITO, Zinkoxid, Aluminiumzinkoxid oder Indium-Zink-Oxid. Alternativ können die Schichten 51 und 52 auch in ihrer Anordnung vertauscht aufgebracht sein. Die zweite Elektrode 5 ist dabei als Kathode ausgeführt. Durch die Kombination der Schicht 51 mit der Schicht 52, also der Kombination der Metallschicht mit der Schicht aus dem transparenten Oxid kann das Reflexionsvermögen der zweiten Elektrode 5 gegenüber einer transparenten Metallelektrode herabgesetzt werden, so dass die in der organischen Schichtenfolge 31 erzeugte elektromagnetische Strahlung effektiv durch die zweite Elektrode 5 abgestrahlt werden kann.

Da die erste Elektrode 2 aus einem TCO besteht und auch das Substrat 1 transparent ausgebildet ist, kann das organische optoelektronische Bauelement 100 beidseitig, also durch die zweite Elektrode 5 sowie durch die erste Elektrode 2 und das Substrat 1 elektromagnetische Strahlung abstrahlen. Weiterhin erscheint das organische optoelektronische Bauelement 100 dadurch transparent und durchsichtig.

In Figur 2 ist ein weiteres Beispiel für ein organisches optoelektronisches Bauelement 200 gezeigt, dass im Vergleich zum organischen optoelektronischen Bauelement 100 des vorherigen Ausführungsbeispiels auch eine erste Elektrode 2 aufweist, die zwei Schichten 21 und 22 umfasst. Die Schicht 21 ist dabei aus einem transparenten Metall ausgeführt, während die Schicht 22 aus einem TCO, beispielsweise ITO ausgebildet ist. Alternativ können die Schichten 21 und 22 auch in ihrer Anordnung vertauscht aufgebracht sein. Wie schon im Zusammenhang mit der zweiten Elektrode 5 im vorherigen Ausführungsbeispiel beschrieben kann dadurch das Reflexionsvermögen der ersten Elektrode 2 effektiv herabgesetzt werden. Dadurch kann verhindert werden, dass sich zwischen den Elektroden 2 und 5 eine optische Mikrokavität dadurch ausbildet, dass ein Teil der in der ersten organischen Schichtenfolge 31 erzeugten elektromagnetische Strahlung an den Elektroden 2 und 5 zur organischen Schichtenfolge zurückreflektiert werden kann. Weiterhin weist das organische optoelektronische Bauelement 200 eine Verkapselung 6 in Form einer freitragenden Kappe auf, die die Elektroden 2 und 5 sowie die erste organische Schichtenfolge 31 vor Feuchtigkeit und Sauerstoff schützen kann, wodurch die Lebensdauer des organischen optoelektronischen Bauelements 200 erheblich gesteigert werden kann. Die Verkapselung 6 ist dabei transparent ausgeführt, beispielsweise aus Glas, so dass das organische optoelektronische Bauelement 200 weiterhin beidseitig emittierend ausgebildet ist.

In Figur 3 ist ein Ausführungsbeispiel für ein organisches optoelektronisches Bauelement 300 gezeigt, bei dem über der zweiten Elektrode 5 eine weitere Schicht 7 aufgebracht ist, die Kohlenstoffnanoröhrchen aufweist. Dadurch kann die Querleitfähigkeit der zweiten Elektrode 5 gesteigert werden, was eine homogenere Aufprägung des Stromes in die erste organische Schichtenfolge 31 zur Folge haben kann.

Weiterhin kann das organische optoelektronische Bauelement 300 wie das organische optoelektronische Bauelement 200 ebenfalls eine Verkapselung aufweisen.

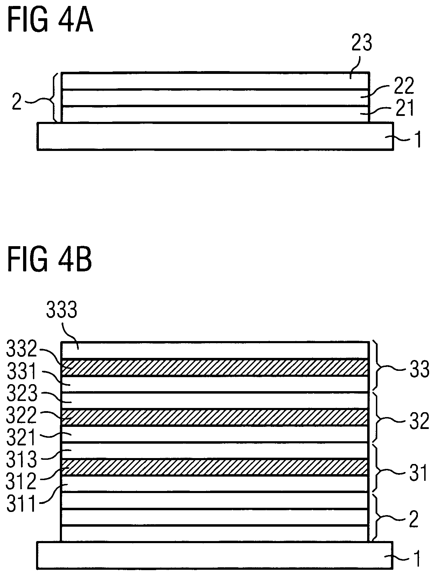

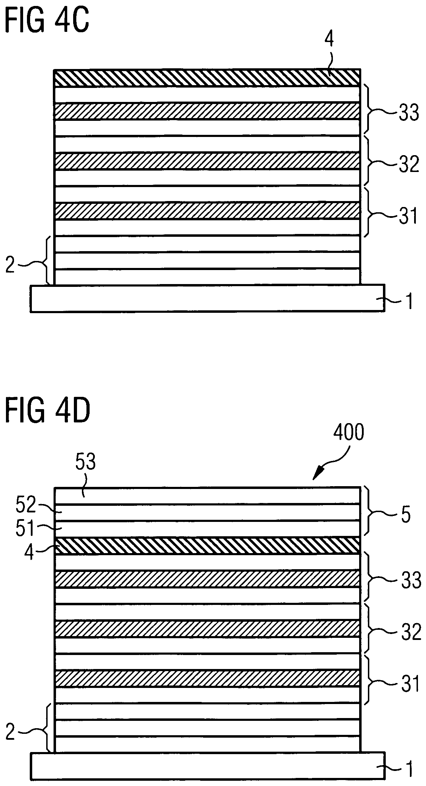

In den Figuren 4A bis 4D ist ein Verfahren zur Herstellung eines organischen optoelektronischen Bauelements 400 gezeigt.

Dabei wird in einem ersten Verfahrensschritt ein Substrat 1 bereitgestellt, etwa ein Glassubstrat (Figur 4A). Alternativ oder zusätzlich kann das Substrat 1 auch beispielsweise Metallfolien oder Plastikfolien aufweisen. Auf das Substrat 1 wird mittel Sputtern eine erste Elektrode 2 abgeschieden, die transparent ausgeführt ist. Die erste Elektrode 2 weist dabei eine erste Schicht 21 aus einem ersten TCO, eine zweite Schicht 22 aus einem transparenten Metall und eine dritte Schicht 23 aus einem zweiten TCO auf. Alternativ zum Sputtern kann auch zumindest eine Schicht 21, 22 oder 23 mittels Verdampfen aufgebracht werden.

Das erste und das zweite TCO weisen beispielsweise ITO, Indiumzinkoxid, oder Zinkoxid auf, das mit Al, V oder Ga dotiert sein kann. Dabei können das erste TCO und das zweite TCO gleich oder verschieden ausgeführt sein. Die Schichten 21 und 23 weisen dabei eine Dicke zwischen etwa 5 nm und etwa 150 nm auf. Die Schicht 22 weist ein transparentes Metall mit einer Dicke von etwa 1 bis etwa 50 nm auf, wobei das Metall Pd, Cu, Al, Cr, Mo, Ni, Ag oder Pt oder eine Mischung oder Legierung daraus ist. Durch die Kombination der zwei TCO-Schichten 21 und 23 mit der eingebetteten transparenten Metallschicht 22 kann eine erste Elektrode 2 realisiert werden, die eine hohe elektrische Leitfähigkeit, insbesondere eine hohe Querleitfähigkeit entlang der Erstreckungsrichtung der ersten Elektrode 2, aufweist sowie einen niedrigen Reflexionskoeffizienten. Dadurch ist die erste Elektrode 2 hochtransparent ausgebildet. Dadurch, dass die erste Elektrode 2 auf dem Substrat 1 abgeschieden wird, kann ein Schritt zum Aufbringen einer Schutzschicht vor dem Aufbringen der ersten Elektrode 2 entfallen.

Wie in Figur 4B gezeigt, werden in weiteren Verfahrensschritten über der ersten Elektrode 2 organische Schichtenfolgen 31, 32 und 33 mittels thermischem oder resistiven Verdampfen aufgebracht. Jede der organischen Schichtenfolgen 31, 32 und 33 weist dabei jeweils organische funktionelle Schichten 311, 312, 313, 321, 322, 323, 331, 332, 333 auf, die als Lochtransportschichten 311, 321, 331, als Elektrontransportschichten 313, 323, 333 und jeweils dazwischen als elektrolumineszierende Schichten 312, 322, 332 wie im allgemeine Teil ausführlich beschrieben ausgeführt sind. Zur Erhöhung der elektrischen Leitfähigkeit können die Lochtransportschichten 311, 321, 331, und die Elektrontransportschichten 313, 323, 333 jeweils dotiert sein, um geringe Betriebsspannungen zu gewährleisten. Jeweils benachbarte Lochtransportschichten und Elektrontransportschichten bilden dabei so genannte "charge generation layer". Im gezeigten Ausführungsbeispiel sind die elektrolumineszierenden Schichten 312, 322, 332 jeweils gleich ausgeführt und emittieren im Betrieb jeweils weiß-farbige elektromagnetische Strahlung. Alternativ kann beispielsweise die elektrolumineszierende Schicht 312 rote, die elektrolumineszierende Schicht 312 grüne und die elektrolumineszierende Schicht 312 blaue elektromagnetische Strahlung abstrahlen, so dass durch Mischung der verschiedenen elektromagnetischen Strahlungen im Betrieb wiederum ein weiß-farbiger Leuchteindruck bei einem Betrachter erweckt werden kann. Zusätzlich können noch weitere gleiche oder andere organischen Schichtenfolgen auf den organischen Schichtenfolgen 31, 32, 33 aufgebracht werden.

Wie in Figur 4C gezeigt wird in einem weiteren Verfahrensschritt mittels thermischen Verdampfens eine anorganische elektrisch leitende Schutzschicht 4 aus einem Übergangsmetalloxid über den organischen Schichtenfolgen 31, 32, 33 abgeschieden. Die Schutzschicht 4 weist dabei ein Übergangsmetalloxid aus Rheniumoxid oder Nickeloxid, wie im allgemeinen Teil ausgeführt, auf. Alternativ kann die Schutzschicht 4 auch derart aufgebracht werden, dass sie in homogener oder nicht-homogener, beispielsweise strukturierter Weise mit einer organischen Schicht durchmischt ist.

Auf der Schutzschicht 4 wird in einem weiteren Verfahrensschritt eine zweite Elektrode 5 aufgebracht, die eine erste Schicht 51 aus einem ersten TCO, eine zweite Schicht 52 aus einem transparenten Metall und eine dritte Schicht 53 aus einem zweiten TCO umfasst. Die Schichten 51, 52, 53 der zweiten Elektrode 5 können dabei ähnlich wie die Schichten 21, 22, 23 der ersten Elektrode 2 oder wie im allgemeinen Teil beschrieben, ausgeführt sein. Dadurch, dass die Schutzschicht 4 auf den organischen Schichtenfolgen 31, 32, 33 aufgebracht ist, ist es möglich, die Schichten 51, 52, 53 mittels Sputtern über den organischen Schichtenfolgen 31, 32, 33 aufzubringen, ohne diese zu schädigen oder zu beeinträchtigen. Auf das organische optoelektronische Bauelement 400 wird noch eine Schicht mit Kohlenstoffnanoröhrchen oder metallischen Nanopartikeln aufgebracht (hier nicht gezeigt). Außerdem kann eine transparente Verkapselung aufgebracht werden (hier nicht gezeigt).

Das derart erhältliche organische optoelektronische Bauelement 400 zeichnet sich durch die Verwendung der mehrschichtigen Elektroden 2, 5 in Verbindung mit der Schutzschicht 4 und die Stapelung der organischen Schichtenfolgen 31, 32, 33 durch eine hohe Transparenz, eine hohe Leuchtleistung und durch eine hohe Lebensdauer aus und kann insbesondere auch als großflächige Anzeige- oder Beleuchtungseinrichtung ausgeführt sein.

## Patentansprüche

1. Organisches optoelektronisches Bauelement, umfassend:
- ein Substrat (1),
- eine erste Elektrode (2) auf dem Substrat (1),
- zumindest eine erste organische Schichtenfolge (31) auf der ersten Elektrode (2), die geeignet ist, im Betrieb elektromagnetische Strahlung abzustrahlen,
- eine elektrisch leitende anorganische Schutzschicht (4) auf der zumindest einen organischen Schichtenfolge (31) und
- eine zweite Elektrode (5) auf der anorganischen Schutzschicht (4),
wobei
- zumindest eine der ersten und zweiten Elektrode (2, 5) eine Schichtenfolge (21, 22, 23) aufweist, die eine transparente Oxidschicht (21) und eine transparente Metallschicht (22) umfasst,
- auf der zweiten Elektrode (5) ein Material (7) aufgebracht ist, das Kohlenstoffnanoröhrchen oder metallische Nanopartikel aufweist
**dadurch gekennzeichnet, dass**
- die anorganische Schutzschicht (4) ein Übergangsmetalloxid aus einer Gruppe umfasst und die Gruppe gebildet wird durch: Rheniumoxid und Nickeloxid.

2. Bauelement nach Anspruch 1, wobei
- die erste Elektrode (2) und die zweite Elektrode (5) transparent für die elektromagnetische Strahlung sind.

3. Bauelement nach einem der vorherigen Ansprüche, wobei
- die erste und die zweite Elektrode (2, 5) jeweils eine Schichtenfolge umfassend eine transparente Oxidschicht (21, 51) und eine transparente Metallschicht (22, 52) aufweisen.

4. Bauelement nach einem der vorherigen Ansprüche, wobei
- zumindest eine der ersten und zweiten Elektrode (2, 5) eine Schichtenfolge (21, 22, 23) umfasst, die eine erste Schicht (21) mit einem ersten transparenten elektrisch leitenden Oxid (TCO), eine zweite Schicht (22) mit einem transparenten Metall und eine dritte Schicht (23) mit einem zweiten TCO aufweist.

5. Bauelement nach einem der vorherigen Ansprüche, weiterhin umfassend:
- zumindest eine zweite organische Schichtenfolge (32), die geeignet ist, im Betrieb elektromagnetische Strahlung abzustrahlen, und die zwischen der ersten Elektrode (2) und der Schutzschicht (4) angeordnet ist.

6. Bauelement nach dem vorherigen Anspruch, wobei
- die erste organische Schichtenfolge (31) und die zweite organische Schichtenfolge (32) in direktem Kontakt miteinander angeordnet sind.

7. Verfahren zur Herstellung eines organischen optoelektronischen Bauelements mit den Schritten:
A) Bereitstellen eines Substrats (1),
B) Aufbringen einer ersten Elektrode (2) auf dem Substrat (1),
C) Aufbringen zumindest einer ersten organischen Schichtenfolge (31) auf der ersten Elektrode (2),
D) Aufbringen einer elektrisch leitenden anorganischen Schutzschicht (4) auf der organischen Schichtenfolge (31),
E) Aufbringen einer zweiten Elektrode (5) auf der Schutzschicht (4),
wobei
Schritt B) und/oder Schritt E) die Teilschritte umfasst:
BE1) Aufbringen einer transparenten Metallschicht (22, 52) und
BE2) Aufbringen einer ersten Schicht (21, 51) mit einem transparenten Oxid mittels eines Kathodenzerstäubungsverfahrens,
wobei in einem weiteren Verfahrensschritt F) eine Schicht (7) auf der zweiten Elektrode (5) aufgebracht wird, wobei die Schicht (7) Kohlenstoffnanoröhrchen und/oder metallische Nanopartikel umfasst
**dadurch gekennzeichnet, dass**
im Verfahrensschritt D) ein Übergangsmetalloxid aus einer Gruppe aufgebracht wird und die Gruppe gebildet wird durch: Rheniumoxid und Nickeloxid.

8. Verfahren nach dem vorherigen Anspruch, bei dem Schritt B) und/oder Schritt E) den weiteren Teilschritt umfasst:
BE3) Aufbringen einer zweiten Schicht (23, 53) mit einem transparenten Oxid,
wobei
- die transparente Metallschicht (22, 52) zwischen den ersten und zweiten Schichten mit jeweils einem transparenten Oxid aufgebracht wird.

9. Verfahren nach Anspruch 7 und 8, bei dem Schritt C) die folgenden Teilschritte umfasst:
C1) Aufbringen einer ersten organischen Schichtenfolge (31) auf der ersten Elektrode (2),
C2) Aufbringen zumindest einer zweiten organischen Schichtenfolge (32) auf der ersten organischen Schichtenfolge (31).

## Claims

1. An organic optoelectronic component, comprising:
- a substrate (1),
- a first electrode (2) on the substrate (1),
- at least one first organic layer sequence (31) on the first electrode (2) which is suitable for emitting electromagnetic radiation during operation,
- an electrically conductive inorganic protective layer (4) on the at least one organic layer sequence (31), and
- a second electrode (5) on the inorganic protective layer (4),
wherein
- at least one of the first and second electrodes (2, 5) has a layer sequence (21, 22, 23) comprising a transparent oxide layer (21) and a transparent metal layer (22),
- a material (7) comprising carbon nanotubes or metallic nanoparticles is applied on the second electrode (5)
**characterized in that**
the inorganic protective layer (4) comprises a transition metal oxide from a group and the group is formed by: rhenium oxide and nickel oxide.

2. The component as claimed in claim 1, wherein
- the first electrode (2) and the second electrode (5) are transparent to the electromagnetic radiation.

3. The component as claimed in any of the preceding claims, wherein
- the first and the second electrode (2, 5) respectively have a layer sequence comprising a transparent oxide layer (21, 51) and a transparent metal layer (22, 52).

4. The component as claimed in any of the preceding claims, wherein
- at least one of the first and second electrodes (2, 5) comprises a layer sequence (21, 22, 23) having a first layer (21) comprising a first transparent electrically conductive oxide (TCO), a second layer (22) comprising a transparent metal and a third layer (23) comprising a second TCO.

5. The component as claimed in any of the preceding claims, furthermore comprising:
- at least one second organic layer sequence (32) which is suitable for emitting electromagnetic radiation during operation and which is arranged between the first electrode (2) and the protective layer (4).

6. The component as claimed in the preceding claim, wherein
- the first organic layer sequence (31) and the second organic layer sequence (32) are arranged in direct contact with one another.

7. A method for producing an organic optoelectronic component, comprising the following steps:
A) providing a substrate (1),
B) applying a first electrode (2) on the substrate (1),
C) applying at least one first organic layer sequence (31) on the first electrode (2),
D) applying an electrically conductive inorganic protective layer (4) on the organic layer sequence (31),
E) applying a second electrode (5) on the protective layer (4),
wherein
step B) and/or step E) comprises the following substeps:
BE1) applying a transparent metal layer (22, 52), and
BE2) applying a first layer (21, 51) comprising a transparent oxide by means of a sputtering method,
wherein, in a further step F), a layer (7) is applied on the second electrode (5), wherein the layer (7) comprises carbon nanotubes and/or metallic nanoparticles
**characterized in that**
in step D), a transition metal oxide from a group is applied and the group is formed by: rhenium oxide and nickel oxide.

8. The method as claimed in the preceding claim, wherein step B) and/or step E) comprises the following further substep:
BE3) applying a second layer (23, 53) comprising a transparent oxide,
wherein
- the transparent metal layer (22, 52) is applied between the first and second layers respectively comprising a transparent oxide.

9. The method as claimed in claim 7 and 8, wherein step C) comprises the following substeps:
C1) applying a first organic layer sequence (31) on the first electrode (2),
C2) applying at least one second organic layer sequence (32) on the first organic layer sequence (31).

## Revendications

1. Composant optoélectronique organique, comprenant
- un substrat (1)
- une première électrode (2) sur le substrat (1),
- au moins une première succession de couches (31) organiques sur la première électrode (2), laquelle est apte à émettre un rayonnement électromagnétique en fonctionnement,
- une couche de protection (4) anorganique électroconductrice sur l'au moins une succession de couches (31) organiques, et
- une deuxième électrode (5) sur la couche de protection (4) anorganique,
- au moins une de la première et de la deuxième électrodes (2, 5) présentant une succession de couches (21, 22, 23) qui comprend une couche d'oxyde (21) transparente et une couche métallique (22) transparente,
- une matière (7) étant appliquée sur la deuxième électrode (5), laquelle matière présente des nanotubes de carbone ou des nanoparticules métalliques,
**caractérisé en ce que**
- la couche de protection (4) anorganique comprend un oxyde métallique de transition d'un groupe, et **en ce que** le groupe est formé par : oxyde de rhénium et oxyde de nickel.

2. Composant selon la revendication 1,
- la première électrode (2) et la deuxième électrode (5) étant transparentes pour le rayonnement électromagnétique.

3. Composant selon l'une quelconque des revendications précédentes,
- la première et la deuxième électrodes (2, 5) présentant respectivement une succession de couches comprenant une couche d'oxyde (21, 51) transparente et une couche métallique (22, 52) transparente.

4. Composant selon l'une quelconque des revendications précédentes,
- au moins une de la première et de la deuxième électrodes (2, 5) comprenant une succession de couches (21, 22, 23), laquelle présente une première couche (21) dotée d'un premier oxyde transparent électroconducteur (TCO), une deuxième couche (22) ayant un métal transparent, et une troisième couche (23) ayant un deuxième TCO.

5. Composant selon l'une quelconque des revendications précédentes, comprenant en outre
- au moins une deuxième succession de couches (32) organiques, laquelle est apte à émettre un rayonnement électromagnétique en fonctionnement, et laquelle est disposée entre la première électrode (2) et la couche de protection (4).

6. Composant selon la revendication précédente,
- la première succession de couches (31) organiques et la deuxième succession de couches (32) organiques étant disposées de manière à être en contact direct l'un avec l'autre.

7. Procédé de fabrication d'un composant optoélectronique organique, comprenant les étapes :
A) la fourniture d'un substrat (1)
B) l'application d'une première électrode (2) sur le substrat (1),
C) l'application d'au moins une première succession de couches (31) organiques sur la première électrode (2),
D) l'application d'une couche de protection (4) anorganique électroconductrice sur la succession de couches (31) organiques,
E) l'application d'une deuxième électrode (5) sur la couche de protection (4),
l'étape B) et/ou l'étape E) comprenant les étapes partielles :
BE1) application d'une couche métallique (22, 52) transparente et
BE2) application d'une première couche (21, 51) ayant un oxyde transparent au moyen d'un procédé de pulvérisation cathodique,
une couche (7) étant appliquée sur la deuxième électrode (5) dans une étape de procédé supplémentaire F), la couche (7) comprenant des nanotubes de carbone et/ou des nanoparticules métalliques,
**caractérisé en ce qu'**
à l'étape D), un oxyde métallique de transition d'un groupe est appliqué, et **en ce que** le groupe est formé par : oxyde de rhénium et oxyde de nickel.

8. Procédé selon la revendication précédente, dans lequel l'étape B) et/ou l'étape E) comprennent l'étape partielle supplémentaire :
BE3) application d'une deuxième couche (23, 53) ayant un oxyde transparent,
- la couche métallique (22, 52) transparente étant appliquée entre la première et la deuxième couches avec respectivement un oxyde transparent,

9. Procédé selon les revendications 7 et 8, dans lequel l'étape C) comprend les étapes partielles suivantes :
C1) application d'une première couche (31) organique sur la première électrode (2),
C2) application d'au moins une deuxième couche (32) organique sur la première succession de couches (31) organiques.
